# EUROPEAN PATENT APPLICATION

(11) **EP 1 083 578 A1**
(43) Date of publication of application: **14.03.2001**
(21) Application number: 00911434.9
(22) Date of filing: 28.03.2000
(51) Int. Cl.: H01B 1/22, H05K 3/46, H05K 3/40, H05K 1/11

(54) **CONDUCTIVE PASTE, CERAMIC MULTILAYER SUBSTRATE, AND METHOD FOR MANUFACTURING CERAMIC MULTILAYER SUBSTRATE**

(30) Priority: 30.03.1999 JP 8918999
(71) Applicant: Matsushita Electric Industrial Co., Ltd., Kadoma-shi, Osaka 571-8501 (JP); Kyoto Elex Co., Ltd., Kyoto-shi, Kyoto 600-8873 (JP)
(72) Inventor: OCHI, Hiroshi, Saijo-shi, Ehime 793-0043 (JP); SEGAWA, Shigetoshi, Niihama-shi, Ehime 792-0050 (JP); BABA, Yasuyuki, Saijo-shi, Ehime 793-0002 (JP); SUEHIRO, Masatoshi, Kyoto Elex Co., Ltd., Kyoto-shi, Kyoto 600-8873 (JP); OGURA, Shinichi, Kyoto Elex Co., ltd., Kyoto-shi, Kyoto 600-8873 (JP)
(74) Representative: Henkel, Feiler, Hänzel
(86) International application number: JP0001922
(87) International publication number: WO0060613

(57) **Abstract**

The present invention pertains to the art of ceramic multilayer substrates, and provides: a conductor paste to give a via conductor which has a low electric resistance value, and involves none of defects such as voids and cracks, and is excellent in quality properties; and a production process by which a ceramic multilayer substrate having excellent quality properties is produced using the above conductor paste.

A conductor paste 20 is plugged into a via hole 12 of a green sheet 10, and a thermal-shrinkage-inhibiting sheet 30 is laminated onto both faces of a green sheet laminate S, and the resultant product is sintered to obtain a ceramic multilayer substrate, with the result that the gap between sintering behaviors of the green sheet 10 and the conductor paste 20 becomes difficult to occur, wherein the conductor paste 20 comprises a conductor powder and an organic vehicle, but is free of glass frit, wherein not less than 95 weight % of the entire conductor powder is composed of an Ag powder having an average particle diameter of 3∼10 µm.

## Description

### Background of the invention

### Technical Field

The present invention relates to a ceramic multilayer substrate used for production of high-density wiring circuit boards and a production process of a ceramic multilayer substrate, and a conductor paste used as a conductor material for these wiring circuit boards.

### Background Art

It is well known that several ceramic green sheets on which wiring circuit patterns are formed are laminated and sintered to obtain a ceramic multilayer substrate as a production process for a high-density wiring circuit.

To connect a circuit of each layer in a ceramic multilayer substrate to a circuit of the corresponding layer, a fine through hole, i.e., via hole is formed on the green sheet composing each layer in advance and the via hole is filled with a conductor paste and the conductor paste which the via hole was filled with is sintered at the same time when the green sheet laminate is sintered.

As a conductor paste for the via hole, a past-state component containing conductive powders such as Ag or Pd, etc. mixed with a glass frit or binder resin is used.

As a method for sintering a green sheet laminate, an art of sintering the green sheet laminate with thermal-shrinkage-constraining sheets laminated onto the both faces of the laminate to constrain shrinkage of the laminate has been proposed. The thermal-shrinkage-constraining sheet is composed of a green sheet containing a ceramic material which will not cause thermal shrinkage or sintering within the sintering temperature range for the green sheet laminate. The thermal-shrinkage-constraining sheet laminated onto the green sheet laminate can prevent the thermal shrinkage of the green sheet laminate. As a specific example, an alumina green sheet is used as a thermal-shrinkage-constraining sheet to be laminated onto the glass ceramic green sheet laminate.

When ceramic multilayer substrates are produced by sintering the green sheet laminate with a conductor paste which the via hole was filled with, this brings about a problem in that voids are produced inside of the via conductor and cracks are generated on the substrate around the via conductor. In addition, electric resistance values of the via conductor sometimes become fairly higher than expected values. Moreover, this brings about a problem that inorganic materials included in said thermal-shrinkage-constraining sheet are stuck on the surface of the via conductor which said thermal-shrinkage-constraining sheet comes in contact with, which remarkably spoils the reliability of connection when another conductor circuit is connected to the surface of the via conductor.

It is assumed that these problems are caused mainly by a gap in the sintering timing or sintering behaviors between the conductor paste which the via hole was filled with and the green sheet laminate. The big gap in the sintering timing between the green sheet laminate and the conductor paste of the via hole causes excessive stress or distortions between the sintered substrate and the via conductor, resulting in generation of said voids or cracks, increase in resistance values and decrease in said connection reliability.

Conventionally, compositions of conductor pastes which the via hole is filled with have been changed to solve said problems. However, sufficient results could have not been obtained only by said method. The reason is based on that even increasing the combination amount of a glass frit has not improved said problem, although said glass frit has been considered as an effective material to adjust sintering properties. In particular, in the method using the said thermal-shrinkage-constraining sheet, the conventional conductor could not be functioned sufficiently.

### Summary of the Invention

### Objectives of the Inventions

An object of the present invention is to eliminate problems involved in the via conductor of said ceramic multilayered substrate, to provide a conductor paste composing a via conductor excellent in electrical and mechanical properties and to produce a ceramic multilayered substrate having excellent properties using said conductor paste.

### Detailed Description of the Invention

### - Conductor paste -

It is preferable that a conductor powder composing an Ag powder having an average particle diameter of 3- 10µm, amounting to 95% or more of the whole weight of a conduct powder and an organic vehicle are included but a glass frit is not included in a conduct paste according the invention.

Use of the conductor paste according to the invention as a via conductor for the ceramic multilayer substrate will have effects such as preventing voids between the via conductor and the substrate, preventing generation of cracks on the substrate and improving electrical properties of resistance values, etc. regarding the via conductor.

A conductor powder is a component that carries out a function of conductance in the sintered via conductor. This is why metals or alloy powders excellent in conductive properties are used for the conductor powder.

A conductor powder is composed of an Ag powder mainly, amounting to 95% or more of the whole weight of a conductor powder.

It is preferable that an Ag powder having an average particle diameter of 3 to 10µm is used. Sintering behaviors vary greatly depended on the particle size. Voids or cracks are likely to be generated whether an average particle diameter is too small or large. If a particle diameter is too small, a via conductor is shrunk earlier than a green sheet when sintering, causing the via conductor to stretch the green sheet and cracks to be generated on the substrate near the via hole. If a particle diameter is too large, the via conductor is sintered later than the substrate, which causing generating voids between the via conductor and the substrate. In addition, the larger a particle diameter of an Ag powder is, the higher resistance values of a via conductor are.

Moreover, materials except for an Ag powder can be mixed with the conductor paste according to the invention as a conductor power within the range in which excellent properties with the Ag powder are not spoiled. As a specific example, a Pd or Pt powder can be used. A Pd or Pt powder has an effect of constraining Ag powders from being sintered. Since a particle diameter of conductor powders other than the Ag powder will affect the properties of the via conductor, it is preferable that a comparatively small particle diameter is used. As a specific example, when using a Pd or Pt powder, a Pd or Pt powder having an average particle diameter of 0.1 - 1µm, amounting to 0.1 - 5% or more of the whole weight of a conductor powder can be mixed. This will have an effect of decreasing resistance values of a via conductor furthermore.

Conventional conductor pastes are composed of additives such as inorganic powders, etc as another component in addition to a conductor powder. In principal, the same additives as those used for conventional conductor pastes can be also included in the conductor paste according to the invention although a glass frit is not added.

To facilitate the handling such as filling the via hole with conductor powders, materials must be turned into a paste state. This is why an organic vehicle must be included. As materials for an organic vehicle, the same materials for conventional conductor pastes are used. For example, an organic vehicle can be given, wherein resins such as an ethyl cellulose are dissolved in a solvent like a terpineol.

For the mixture ratio between a conductor powder and an organic vehicle, a general mixture rate can be employed. For example, conductor powders and organic vehicles are mixed in a ratio of 80 - 95 to 20 - 5 usually.

### - Production process for ceramic multilayer substrates -

A production process for ceramic multilayer substrates according to the present invention is performed by laminating and sintering several ceramic green sheets, comprising:
a process in which a via hole created on a green sheet is filled with said conductor paste according to the invention;
a process in which a laminate for sintering is obtained by laminating several green sheets which are filled with conductor pastes;
a process in which a ceramic multilayer substrate is obtained by sintering green sheets for lamination and sintering and conductor pastes.

It is preferable that a ceramic multilayer substrate according to the invention is obtained by laminating and sintering several ceramic green sheets whose surfaces circuit wiring patterns are printed on;
wherein a green sheet has a via hole which is filled with a conductor paste;
wherein a conductor paste to be plugged into a via hole is composed of a conductor powder containing an Ag powder having an average particle diameter of 3 - 10µm, amounting to 95% or more of the whole weight of a conduct powder and an organic vehicle but is not composed of a glass.

### Brief Description of the Drawings

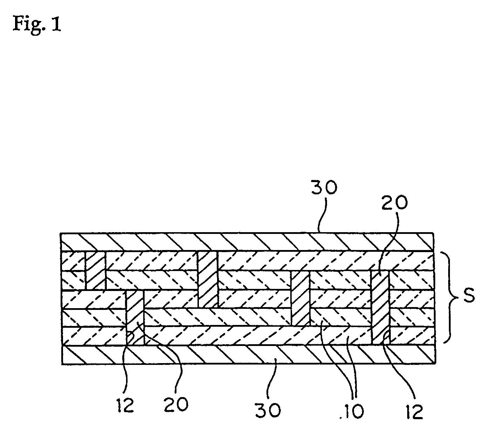

Fig. 1 is a sectional view of a green sheet laminate according to Example of the present invention.
Fig. 1 is composed of a green sheet 10, a via hole 12, a conductor paste 30, a thermal-shrinkage-constraining sheet and a green sheet laminate.

### Description of the Preferred Embodiments

Fig. 1 shows a structure of a laminate at the stage where a sintering process is carried out in Example of the invention.

A green sheet 10 is made by preparing slurry as a glass ceramic material and molding the prepared slurry to a sheet state. A green sheet 10 has a via hole 12 which is penetrated and formed in a predetermined position during the punching process. A ceramic green sheet can be composed of the same materials used for a production process of conventional ceramic multilayer subsances. In particular, an alumina, glass ceramics, etc. are used as a ceramic material. A dimensional shape of a via hole can be employed in the same way as conventional multilayer substrates. A lay out pattern of via holes are determined by a circuit design. A diameter in a via hole is approx. 0.1 to 0.3mm.

A required sheets of green sheets 10 are laminated to form a laminate sheet S. In a laminate sheet S, via holes 12 in several green sheets 10 are connected to each other. Number of lamination of green sheets can be set if necessary. The range from several to several dozens can be set.

The inside of a via hole 12 is filled with a conductor paste 20. Said method for filling with a conductor paste according to the invention can be the same as the production process of conventional circuit boards. In other words, each via hole 12 for an individual green sheet 10 can be filled with a conductor paste 20 or an operation of filling an opening via hole 12 on the surface with a conductor paste 20 can be repeated while laminating a green sheet 10 serially. A screen printing method can be applied to the method for lamination of a conductor paste 20.

Although a sketch is omitted, a wiring circuit pattern can be formed onto a surface of a green sheet 10. A wiring circuit pattern can include not only a conductor circuit but also a functional section such as a resistance. For a wiring circuit pattern, the same conductor paste as a conductor paste 20 for a via hole can be formed by a screen printing. A screen printing allows a via hole to be filled with a conductor paste 20 and forming of a surface circuit at the same time. It is a matter of course that a conductor paste suitable for forming a surface circuit, which is different from a conductor paste in component mixture can be used. A wiring circuit pattern can be connected to said conductor paste which the via hole was filled with.

This green sheet can be sintered alone. However, it is preferable that sintering is performed using a thermal-shrinkage-constraining sheet. Accordingly, thermal-shrinkage-constraining sheets 30, 30 composing an alumina green sheet is installed onto both faces of a green sheet laminate S.

When a green sheet laminate is sintered, a thermal-shrinkage-constraining sheet 30 functions as a sheet material to constrain a green sheet 10 from shrinking excessively and is composed of a lower material in thermal expansion coefficient than that of a green sheet 10 within a sintering temperature range of a green sheet laminate S. For example, if a green sheet that is composed of glass ceramics that is sintered at low temperatures comparatively, alumina ceramics with little thermal expansion within the range of the sintering temperature of the glass ceramics can be used for the green sheet. Protective films (not illustrated) can be installed onto both faces of a green sheet laminate or outside of a thermal-shrinkage-constraining sheet. A protective film is used to protect a comparatively soft green sheet when transferring a green sheet laminate S from a lamination process to a pressurizing process or storing a green sheet laminate S temporarily. A synthetic resin such as a PPS or a PET is used for the protective film. A protective film is attached to a laminate and carries out a protective function during treatment from the preliminary pressurizing process to the pressurizing process.

A laminate that is composed of this green sheet laminate S and the thermal-shrinkage-constraining sheet 30 is fed to a heating furnace for sintering and is heated at appropriate temperatures around 1000°C to be sintered. The same process for sintering conventional ceramic multilayer substrates are applied to the sintering process for the green sheet and conductor paste. Sintering temperatures and time are determined according to materials used for a green sheet or required properties.

A green sheet 10 and conductor paste 20 undergo thermal shrinkage, accompanying with sintering. If thermal-shrinkage-constraining sheets are laminated onto both faces of a green sheet laminate, the thermal-shrinkage-constraining sheets laminated onto both faces can constrain the thermal shrink of a green sheet during the sintering process.

When the sintering process is completed, a ceramic multilayer substrate is obtained as a resultant product which a green sheet laminate S is sintered and changed to. A thermal-shrinkage-constraining sheet 30 is removed from the ceramic multilayer substrate.

The ceramic multilayer substrate obtained after the sintering process is completed, undergoes a post process as required. For example, a wiring circuit pattern is prepared on the surface of the ceramic multilayer substrate, a electronic element is mounted on the substrate and the ceramic multilayer substrate is combined with other electronic components.

Effects of the invention are described using actual and comparison samples shown in Example as follows.

### Example

### [Conductor paste]

A conductor paste that is composed of components shown in the table listed below was produced and quality properties were evaluated.

As a specific example, 5-25 weight of ethyl cellulose dissolved in a terpinelol was added to 100 weight of conductor paste that is composed of an Ag powder alone or an Ag powder and Pd powder having an specific average particle diameter and 5 - 25 weight of the resultant product was sufficiently mixed and kneaded using an equipment having three rolls to obtain a conductor paste.

"Glass addition amount" shown in Table 1 indicates an addition amount of glass frit (average particle diameter: 1.5 - 2.0µm, glass transition point: 670°C, crystallization temperature: 980°C).

### [Green sheet]

A glass ceramic green sheet which is mainly composed of a lead borosilicate glass and an alumina mainly was used. On the green sheet, a 0.2mm diameter of a via hole was processed.

Said conductor paste which a via hole on a green sheet was filled with.. A conductor paste used for an inner layer circuit, which is mainly composed of an Ag powder was printed on a surface of a green sheet using a screen printing to obtain a inner layer circuit pattern.

Several green sheets underwent the same processing and were laminated to obtain a green sheet laminate.

A thermal-shrinkage-constraining sheet which is composed of an alumina green sheet was laminated on both faces of the green sheet laminate. Sintering temperatures of an alumina green sheet are 1300 to 1500°C, which are sufficiently higher than those of a glass ceramic green sheet.

The green sheet laminate and the thermal-shrinkage-constraining sheet were combined into one laminate by applying pressure of 100 to 200kg/cm² at 80 to 100°C.

The laminate was dewaxed by heating at 400 to 700°C and then it was sintered at 900°C for 10 to 15 minutes.

An effect of the thermal-shrinkage-constraining sheet constrained the resultant ceramic multilayer substrate from shrinking in a horizontal direction preferably.

The results evaluated by analyzing the resultant ceramic multilayer substrate are shown in Table 1.

"Electric resistance value of via hole" in evaluation items indicates an electric resistance value for each via conductor. For "voids, cracks", voids generated between a via conductor and a via hole or a wiring circuit, or presence of cracks generated on the substrate were observed. For "powder sticking", whether an alumia powder as a material for the thermal-shrinkage-constraining sheet is stuck on the surface of the via conductor on the surface of the ceramic multilayer substrate was observed.

**[Table 1]**

| | Composition of conductor power Weight % (particle diameter µm) | | Glass additives | Electric resistance value for via | Presence of voids or cracks | Presence of stuck powders |
|---|---|---|---|---|---|---|
| | Ag | Pd | | | | |
| Example 1 | 99 ( 3) | 1 (1.0) | 0 | 0.8 | No | No |
| Example 2 | 99 ( 5) | 1 (0.5) | 0 | 0.9 | No | No |
| Example 3 | 99 (10) | 1 (0.1) | 0 | 1.0 | No | No |
| Example 4 | 95 ( 3) | 5 (0.5) | 0 | 1.0 | No | No |
| Example 5 | 95 ( 5) | 5 (1.0) | 0 | 1.5 | No | No |
| Example 6 | 100 (10) | - | 0 | 1.5 | No | No |
| Comparison sample 1 | 95 ( 1) | 5 (1.0) | 0 | 1.0 | Yes | No |
| Comparison sample 2 | 100 (15) | - | 0 | 5 | Yes | Yes |
| Comparison sample 3 | 70 ( 1) | - | 30 | 20 | Yes | No |
| Comparison sample 4 | 80 ( 5) | 5 (1.0) | 20 | 20 | Yes | Yes |
| Comparison sample 5 | 90 (10) | - | 10 | 15 | Yes | Yes |

As shown above, it is found that a ceramic multilayer substrate having a via conductor excellent in quality properties such as a low resistance value, no voids or cracks, no stuck alumina powder can be obtained in Example according to the prevention. When comparing Example 6 to Example 3, usefulness of mixing a little amount of Pd powder is proven since mixing a small amount of a Pd powder is added to an Ag powder decreased an electric resistance value of a via.

On the other hand, voids or cracks are generated since an Ag power has a small particle diameter in Examples 1 and 3. In Example 2, since an Ag power has a large particle diameter, voids or cracks are generated and an alumina power is stuck. In Examples 3 through 5, addition of a glass frit causes electric resistance values to increase greatly and voids or stuck alumia powders to generate.

A metal or alloy powder excellent in conductance must be used for a conductor powder as a component which carries out a conductance function in the via conductor after sintering. As described above, a conductor powder according to the invention is composed mainly of an Ag powder amounting to 95% or more of the whole weight of a conduct powder. In addition, it is important that an average particle diameter is 3 to 10 µm. Sintering behaviors vary greatly depended on size of a particle diameter and voids or cracks are likely to be generated whether an average particle diameter is too small or too large. If an average particle is too small, a via conductor is shrunk earlier than a green sheet and the via conductor stretches a green sheet, causing cracks to be generated on a substrate around a via hole. If a particle diameter is too large, voids are generated between a via conductor and a substrate since a via conductor is sintered later than a substrate. In addition, the larger a particle diameter of an Ag powder is, the larger resistance values of a via conductor are.

In addition to an Ag powder, another material can be included in a conductor powder within the range in which excellent properties in an Ag powder are not spoiled. As a specific example, a Pd powder or an Pt powder can be used. A Pt powder and Pt powder constrains an Ag powder from sintering and have an effect to decrease an electric resistance value of a via conductor. Since even a particle diameter of a conductor powder other than an Ag powder affects properties of a via conductor, it is preferable that a comparatively small particle diameter is used. As a specific example, it is preferable that a Pd powder and a Pt powder having an average particle diameter of 0.1 to 1µm are used. A too small particle diameter constrains an Ag powder from sintering insufficiently and a too large particle diameter constrains an Ag powder from sintering excessively.

In addition, it is more important that although additives such as glasses or inorganic powders in addition to a conductor powder can be included in conventional conductor pastes, a glass frit cannot be included in a conductor paste according to the invention.

Moreover, it is necessary to turn materials into a paste state by including an organic vehicle to facilitate the handling such as filling the via hole with conductor powders. As materials for a organic vehicle, the same materials for conventional conductor pastes are used. For example, an organic vehicle can be given, wherein resins such as an ethyl cellulose are dissolved in a solvent like a terpineol.

For the mixture ratio between a conductor powder and an organic vehicle, a general mixture rate can be employed. For example, conductor powders and organic vehicles are mixed in a ratio of 80 - 95 to 20 - 5 usually.

### Industrial Field of the Invention

As specifically described, in a production process for a conductor paste and a ceramic multilayer substrate accroding to the invention, a conductor powder is composed mainly of an Ag powder having a special particle diameter but not of a glass frit, which does not cause a big gap between sintering behaviors of a conductor paste and a green sheet. As a result, a sintered ceramic multilayer substrate is not likely to generate voids between a via conductor and a substrate, or to generate cracks in a substrate and have excellent properties in electrical characteristics such as an electric resistance value.

In particular, when a green sheet laminate is sintered while constraining a green sheet laminate from shrinking thermally using a thermal-shrinkage-constraining sheet, sintering in combination with a green sheet and a conductor paste can be carried out preferably and excellent properties of a via conductor on a ceramic multilayer substrate can be obtained.

## Claims

1. A conductor paste comprising:
a conductor powder which is composed of an Ag powder having an average particle diameter of 3 to 10 µm, amounting to 95% or more of the whole weight of a conduct powder;
an organic vehicle;
not a glass frit.

2. The conductor paste according to claim 1,
wherein said conductor powder comprising:
a Pd powder and/or a Pt powder having an average particle diameter of 0.1 to 1 µm, amounting to 0.1 to 5 % of the whole weight of the conductor powder

3. A production process in which several ceramic multilayer substrates are laminated and sintered to obtain a ceramic multilayer substrate comprising:
a process in which a via hole of said green sheet is filled with the conductor paste according to any of claim 1 or claim 2;
a process in which several green sheets which were filled with said conductor paste are laminated to obtain a laminate for sintering;
a process in which said laminate for sintering and the conductor paste are sintered to obtain a ceramic multilayer substrate.

4. The production method for the ceramic multilayer substrate according to Claim 3 comprising,
wherein a process in which a laminate for sintering is obtained by installing thermal-shrinkage-constraining sheets onto both faces of said laminate for sintering before sintering;
a process in which said thermal-shrinkage-constraining sheet is removed after sintering said laminate for sintering.

5. A production process according to any of claim 3 and claim 4 comprising, wherein a process in which a wiring pattern is prepared on the surface of the ceramic multilayer substrate produced by said process method.

6. A ceramic multilayer substrate which is obtained by laminating and sintering several green sheets whose surfaces a circuit wiring pattern is printed on comprising:
wherein said ceramic green sheet have a via hole which is filled with a via conductor;
wherein a via conductor which is filled with said via hole contains a conduct powder which is composed of a Ag powder having an average particle diameter of 3 - 10µm amounting to 95% or more of the whole weight of a conductor powder but does not contain a glass frit.

7. A ceramic multilayer substrate according to claim 6 comprising:
wherein, said ceramic green sheet have a circuit wiring pattern printed on the surface.

8. A ceramic multilayer substrate according to claim 6 and clam 7 comprising:
wherein, a conduct powder of said via conductor is composed of a Pd powder and/ or Pt powder having an average particle diameter of 0.1 to 5 weight amounting to 95% or more of the whole weight of a conduct powder.
